# EUROPÄISCHE PATENTANMELDUNG

(11) **EP 2 109 163 A1**
(43) Veröffentlichungstag der Anmeldung: **14.10.2009**
(21) Anmeldenummer: 08405100.2
(22) Anmeldetag: 08.04.2008
(51) Int. Cl.: H01L 51/40

(54) **Substrat mit aufgedruckter Struktur**

(71) Anmelder: Alcan Technology & Management Ltd., 8212 Neuhausen am Rheinfall (CH)
(72) Erfinder: Lohwasser, Wolfgang, 78262 Gailingen (DE); Kiy, Michael, 8404 Winterthur (CH); Reinhold, Matthias, 8212 Neuhausen (CH); Weber, Christian, 78262 Gailingen (DE)

(57) **Zusammenfassung**

Bei einem Substrat (10) mit hydrophiler Oberfläche und einer auf der hydrophilen Oberfläche aufgedruckten Struktur (16) aus einem leitfähigen und oder lichtemittierenden organischen Polymer ist die hydrophile Oberfläche von einer auf dem Substrat angeordneten Schicht aus einem oxidkeramischen (12) und/oder metallischen (14) Material gebildet.

## Beschreibung

Die Erfindung betrifft ein Substrat mit hydrophiler Oberfläche und einer auf der hydrophilen Oberfläche aufgedruckten Struktur aus einem leitfähigen und / oder lichtemittierenden organischen Polymer.

Leitfähige und lichtemittierende organische Polymere lassen sich durch geeignete Drucktechniken relativ einfach und kostengünstig auf ein Substrat aufbringen. Insbesondere bei der Herstellung mikroelektronischer Bauelemente muss das leitfähige Material entsprechend der zu erzielenden Schaltungslogik als Struktur mit hoher räumlicher Auflösung auf das Substrat aufgedruckt werden können. Gleiches gilt bei der Herstellung von Farbdisplays und organischen Leuchtdioden (OLED) für das lichtemittierende Polymer.

Aus DE-A-102 40 105 ist ein Verfahren zur Herstellung einer Struktur aus einem leitfähigen organischen Polymer auf einem Substrat mittels Gravurdruck bekannt. Der strukturierte Druckstempel weist eine hydrophobe und das Substrat eine hydrophile Oberfläche auf, und die Drucklösung ist hydrophil. Das Substrat ist aus einem oxidischen Material, wie z.B. Glas oder Keramik, oder aus einem Metall, wie z. B. Kupfer oder Nickel, gefertigt. Weitere, zur Herstellung des Substrats geeignete Werkstoffe sind Polymere, die Hydroxylgruppen enthalten, wie z. B. Polyvinylpyrrolidon, oder auch Polymere die nachträglich mit Hydroxylgruppen funktionalisiert werden, beispielsweise durch eine Behandlung im Sauerstoffplasma.

Aus DE-A-102 36 404 ist es bekannt, bei einem Substrat zum Aufdrucken eines leitfähigen oder lichtemittierenden Polymers mittels Tintenstrahldruck zur Erzielung einer hohen räumlichen Auflösung die mit dem Polymer zu bedruckenden Bereiche einer UV-Ozon- oder einer Sauerstoffplasma-Behandlung zu unterziehen.

Nachteile von Plasma- und Coronabehandlungen von Kunststoffoberflächen zur Anpassung der Oberflächenspannung sind eine nicht dauerhafte Stabilität und eine ungenügende Reproduzierbarkeit der auf dies Weise behandelten Oberflächen.

Der vorliegenden Erfindung liegt die Aufgabe zugrunde, ein Substrat der eingangs genannten Art mit einer reproduzierbaren und dauerhaft stabilen hydrophilen OberFläche bereitzustellen. Ein weiteres Ziel der Erfindung ist die Schaffung eines flexiblen Substrats der eingangs genannten Art auf der Basis einer Kunststofffolie.

Zur erfindungsgemässen Lösung der Aufgabe führt, dass die hydrophile Oberfläche von einer auf dem Substrat angeordneten Schicht aus einem oxidkeramischen und/oder metallischen Material gebildet ist.

Eine Beschichtung mit einem oxidkeramischen Material hat neben der Bereitstellung einer hydrophilen Oberfläche den weiteren Vorteil, dass sie zusätzlich als Barriere gegen den Durchtritt von Wasserdampf wirkt und die mit einem oxidkeramischen Material beschichteten Substrate deshalb besonders für wasserempfindliche Bauelemente, wie sie in der Polymerelektronik beispielsweise in der Form von Polymer-Schaltungen, Polymersolarzellen oder Polymer-Leuchtdioden verwendet werden, geeignet sind.

Bevorzugt enthält die auf dem Substrat angeordnete Schicht eine Verbindung der Formel SiOₓ oder besteht ganz aus SiOₓ, wobei x eine Zahl von 0.9 bis 2.0, vorzugsweise eine Zahl zwischen 1.5 und 1.8, ist.

Die oxidkeramische Schicht kann hergestellt sein mit Verfahren der Vakuumdünnschichttechnik, insbesondere auf der Basis von Elektronenstrahlverdampfen oder Widerstandsheizen oder induktivem Heizen von zu verdampfenden Materialien, bekannt z.B. als Aufdampfmaterialien, Targetmaterialien oder Targets. Bevorzugt ist das Elektronenstrahlverdampfen. Die beschriebenen Verfahren können reaktiv und/oder mit lonenunterstützung gefahren werden. Diese Verfahren werden derart ausgeführt, dass im Vakuum die zu verdampfenden Materialien aus z.B. Mischungen von Siliziumdioxid (SiO₂) mit metallischem Silizium als zu verdampfende Materialien im Vakuum einer Vakuumkammer verdampft werden. In der Vakuumkammer schlägt sich eine keramische Schicht aus oder enthaltend die Verbindungen der Formel SiOₓ auf dem Substrat vollflächig nieder und bildet die oxidkeramische Schicht.

Dem SiO₂ können als zu verdampfende Materialien weitere Zusätze, wie Al₂O₃, B₂O₃ und/oder MgO, in Mengen von beispielsweise 5 bis 30 Mol-%, jeweils bezogen auf das SiO₂, zugesetzt werden. Dem SiO₂ können als zu verdampfende Materialien auch Al, B und/oder Mg als weitere Zusätze in reiner Form oder als Si-Legierung zugesetzt werden. Die Zusätze von Al, B und/oder Mg können in Mengen von beispielsweise 5 Mol-% bis 30 Mol-%, jeweils bezogen auf das Si, zugesetzt werden. Die Mengenverhältnisse der sauerstoffhaltigen Verbindungen, wie SiO₂, Al₂O₃, B₂O₃ und MgO, zu den Metallen bzw. Halbmetallen werden beispielsweise derart gewählt, dass sich stöchiometrisch ein Sauerstoffmangel von 10 bis 30%, bezogen auf die Summe der reinen Oxide im abgedampften Material, ergibt.

Das Beschichtungsverfahren wird über die Verdampfungsrate des Tiegelmaterials, die Abscheidungsrate auf dem Substrat und die Expositionsdauer des Substrats in der Vakuumkammeratmosphäre derart gesteuert, dass die auf dem Substrat abgeschiedene Schicht des oxidkeramischen Materials eine Dicke von 50 nm (Nanometer) bis 2000 nm, vorzugsweise 100 bis 1000 nm, insbesondere 150 bis 500 nm, aufweist.

Die auf dem Substrat angeordnete Schicht aus Metall besteht beispielsweise aus Chrom, Aluminium, Nickel, Titan, Eisen, Molybdän oder aus einer wenigstens zwei dieser Metalle zusammengesetzten Legierung. Bevorzugte Metalle sind Chrom und Aluminium, wobei Chrom besonders bevorzugt ist. Eine bevorzugte Legierung ist V2A-Stahl.

Überraschend hat sich gezeigt, dass bereits eine monoatomare Metallschicht für eine Substratoberfläche mit guten hydrophilen Eigenschaften ausreichend ist. Monoatomar heisst dabei nicht, dass die Atome in einer monoatomaren Lage angeordnet sein müssen. Vielmehr bilden sich wie bei allen Kondensationsprozessen Cluster von Atomen. Unter einer monoatomaren Schicht wird hier eine Flächenbelegung verstanden, die zu einer annähernd monoatomaren Lage führen würde, wenn man die Atome gleichmässig über die Substratfläche verteilen würde.

Obschon auch dickere Metallschichten Verwendung finden können, wird aus Kostengründen und zur Gewährleistung einer hohen optischen Transparenz eine Dicke von max. 5 nm, insbesondere eine einer monoatomaren Belegung entsprechende Schichtdicke von 0.1 bis 0.5 nm, bevorzugt. Diese geringen Schichtdicken reichen völlig aus, um die Oberflächeneigenschaften des Substrats zu verändern. Die optische Transparenz und die lsolationseigenschaften des beschichteten Substrats werden nahezu nicht verändert.

Das Substrat kann auch mit einer ersten Schicht aus oxidkeramischem Material und einer auf der ersten Schicht angeordneten zweiten Schicht aus Metall, oder mit einer ersten Schicht aus Metall und einer auf der ersten Schicht angeordneten zweiten Schicht aus oxidkeramischem Material, ausgestattet sein.

Bevorzugt ist eine erste Schicht aus SiOₓ einer Dicke von 50 bis 2000 nm, vorzugsweise 100 bis 1000 nm, insbesondere 150 bis 500 nm, und eine auf der ersten Schicht aus SiOₓ angeordnete zweite Schicht aus Metall einer Dicke von max. 5 nm, vorzugsweise einer monoatomaren Belegung entsprechenden Schichtdicke von 0.1 bis 0.5 nm.

Die Metallschicht kann beispielsweise durch ein weiteres Vakuumdünnschichtverfahren, wie oben beschrieben, mit einem der genannten Metalle als zu verdampfendes Material, oder bevorzugt durch Sputtern mit einem der genannten Metalle als Target, aufgetragen werden. Bei kontinuierlichen Beschichtungsprozessen kann das Substrat in einer ersten Kammer zuerst mit der oxidkeramischen Schicht versehen, anschliessend durch eine Spaltschleuse geleitet und in einer weiteren Kammer durch Sputtern mit der Metallschicht versehen werden.

Bevorzugte Substrat sind Kunststofffolien, insbesondere aus einem Polyester, vorzugsweise aus Polyethylenterephtalat (PET), aus orientiertem Polyamid (oPA) oder aus orientiertem Polypropylen (oPP). Das Substrat kann auch eine mehrschichtige Folie sein, wobei zumindest die zu bedruckende Folienoberfläche eine Schicht aus Kunststoff ist.

Die Metallschicht kann in Linie mit der im Vakuumdünnschichtverfahren aufzutragenden oxidkeramischen Materials auf dem Substrat abgeschieden. Da eine sehr dünne Metallschicht zur Erzielung der geforderten Oberflächeneigenschaften bereits ausreicht, ist es möglich, diese Schicht mit einer Sputterkathode bei sehr hohen Bandgeschwindigkeiten, die mit dem Aufdampfprozess kompatibel sind, zu sputtern.

Durch die geringe erforderliche Schichtdicke der Metallschicht ist es möglich, dass man eine Beschichtungsquelle z. B. eine Sputterkathode, ohne Beschichtungswalze zwischen zwei Umlenkwalzen anordnet (Free-Span-Betrieb).

Die auf dem Substrat aufgedruckten leitfähigen Polymere können in polymeren Schaltungen, wie Polymertransistoren, transparenten leitfähigen Schichten in Solarzellen, Leuchtdioden und als Widerstand, z.B. in Sensoren, benutzt werden. Weitere Anwendungsmöglichkeiten sind antistatische Beschichtungen. Die Kombination mit SiOₓ hat zusätzlich noch Barrierewirkung gegen Wasserdampf und ist daher besonders für wasserempfindliche Bauelemente geeignet, wie sie in der Polymerelektronik als Polymer-Schaltungen, Polymer-Solarzellen und Polymer-Leuchtdioden verwendet werden.

Das Aufdrucken der Struktur aus dem leitfähigen und/oder lichtemittierenden Polymer kann mit allen gängigen Druckverfahren, z. B. Offset-, Gravur-, Sieb-, Flexo- oder Inkjet-Verfahren, durchgeführt werden.

Die Polymere werden in der Form wässriger Dispersionen aufgetragen und nachfolgend getrocknet. Geeignete leitfähige Polymere sind z. B. 3,4-Polyethylendioxythiophen / Polystyrolsulfonat (PEDOT:PSS, Baytron^{®}) oder Polyanilin. Geeignete lichtemittierende Polymere sind z. B. Polymere aus der Familie der Polyphenylenvinylene (PPV) oder der Polyfluorene.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt schematisch in
- Fig.1: den Aufbau eines beschichteten Substrats;
- Fig. 2: eine Vorrichtung zur Herstellung des beschichteten Substrats von Fig. 1.

Ein Substrat 10 aus einem beispielsweise 12 µm dicken Kunststofffilm aus PET ist mit einer beispielsweise 80 nm dicken keramischen Schicht 12 aus SiOₓ, wobei x beispielsweise 1.8 ist, durch Aufdampfen im Vakuum beschichtet. Auf der keramischen Schicht 12 ist eine beispielsweise 0.2 nm dicke, im Vakuum durch Sputtern aufgetragene Metallschicht 14 aus Chrom angeordnet. Die Metallschicht 14 ist mit einer mittels Gravurdruck aufgetragenen leitfähigen Struktur 16 aus einem leitfähigen Polymer, z. B. aus 3,4-Polyethylendioxythiophen /Polystyrolsulfonat (PEDOT:PSS, Baytron®), bedruckt.

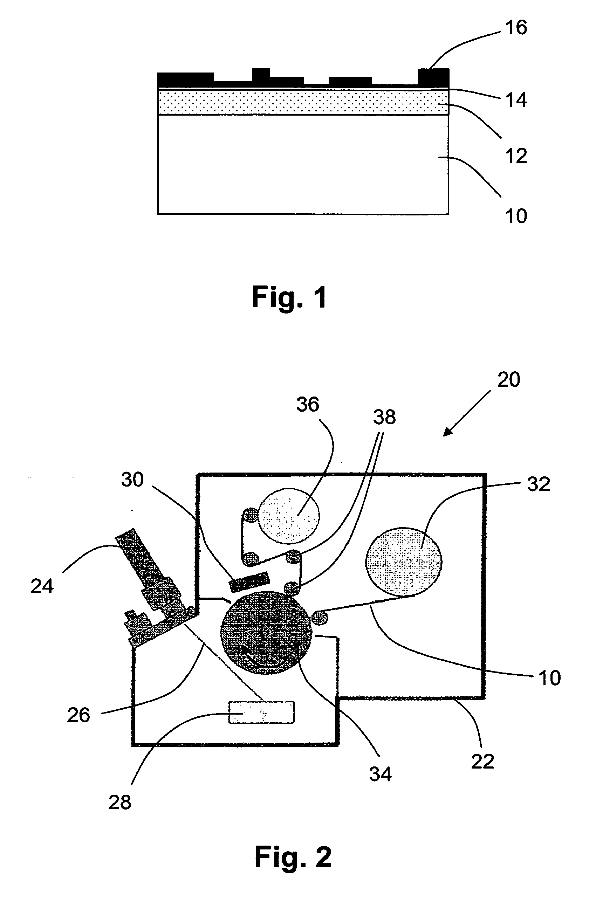

Eine in Fig. 2 dargestellte Beschichtungsanlage 20 weist eine Vakuumkammer 22 auf. Ein von einer Elektronenstrahlkanone 24 emittierter Elektronenstrahl 26 wird auf das in einem Tiegel oder in einer Platte vorhandene Material 28 gelenkt, wobei sich das Material 28 zur Erzeugung der keramischen Schicht 14 durch die Energie des auftreffenden Elektronenstrahls 26 erhitzt und verdampft.

Innerhalb der Vakuumkammer ist auch ein zur Bildung der dünnen Metallschicht erforderliches Metall bzw. die Legierung in Form einer Metallplatte auf einer Sputterkathode 30 aufgelötet. In der Vakuumkammer 22 wird eine Argon-Atmosphäre bei einem Druck von 3.10⁻³ mbar aufrechterhalten. Die elektrische Leistung für die Sputterkathode wird der gewünschten Schichtdicke entsprechend eingestellt.

Innerhalb der Vakuumkammer 22 wird der Substratfilm 10 von einer ersten Rolle 32 abgewickelt und über eine Walze 34 gezogen. Der auf der Walze 34 als Substratträger aufliegende Substratfilm 10 bildet im Arbeitsbereich eine Substratfläche, auf welcher das vom Elektronenstrahl 26 der Elektronenstrahlkanone 24 verdampfte Material 28 in Form der keramischen Schicht 12 abgeschieden wird. Auf die auf dem Substratfilm 10 niedergeschlagene keramische Schicht 12 wird die dünne Metallschicht 14 durch Sputtern aufgetragen. Nach erfolgter Beschichtung mit der keramischen Schicht 12 und der Metallschicht 14 wird der derart beschichtete Substratfilm 10 auf eine weitere Rolle 36 aufgewickelt. Zur Führung des Substratfilms 10 sind Umlenkrollen 38 vorgesehen. Die Bandgeschwindigkeit des Substratfilms 10 in der Vakuumkammer 22 liegt beispielsweise bei etwa 400m/min. Der auf die Rolle 36 aufgewickelte, mit der keramischen Schicht 12 und der Metallschicht 14 beschichtete Substratfilm 10 wird anschliessend - in der Zeichnung aus Gründen der besseren Übersicht nicht dargestellt - in einer Druckmaschine mit der Struktur aus dem leitfähigen Polymer versehen.

### Beispiel 1

Ein als Substrat dienender, 12 µm dicker Film aus Polyethylenterephthalat (PET) wird in Linie zuerst mittels eines Sauerstoffplasmas vorbehandelt, anschliessend im Vakuum mittels Elektronenstrahl-Bedampfung mit 80 nm SiO_{1.8} beschichtet. Danach erfolgt eine Beschichtung mit Chrom. Die Bandgeschwindigkeit beträgt 200 m/min, die Beschichtungsbreite liegt bei 690 mm. Die Beschichtung mit Chrom erfolgt auf derselben Beschichtungswalze, auf der auch die SiO_{1.8} -Beschichtung durchgeführt wird, mittels einer DC-Magnetronsputterkathode (PK750 von Leybold), auf der eine Chrom-Platte als Target aufgelötet ist. Die Abscheidung erfolgt in einer Argon-Atmosphäre bei 3.10⁻³ mbar. Die elektrische Leistung für die Sputterkathode beträgt 10 kW. Unter diesen Bedingungen ergibt sich eine Schichtdicke von etwa 1.5 Ångström (0.15 nm).

Auf ein, wie vorstehend beschrieben, im Vakuum beschichtetes Substrat wurden in einer Druckmaschine mikroelektronische Bauelemente mittels Gravurdruck mit einer wässrigen Dispersion aus 3,4-Polyethylendioxythiophen /Polystyrolsulfonat (PEDOT:PSS, Baytron^{®} FE) aufgedruckt und nachfolgend in einem warmen Luftstrom getrocknet. Die aufgedruckten Bauteile zeigten eine hohe räumliche Auflösung.

## Patentansprüche

1. Substrat mit hydrophiler Oberfläche und einer auf der hydrophilen Oberfläche aufgedruckten Struktur (16) aus einem leitfähigen und/oder lichtemittierenden organischen Polymer,
**dadurch gekennzeichnet, dass**
die hydrophile Oberfläche von einer auf dem Substrat (10) angeordneten Schicht (12, 14) aus einem oxidkeramischen und/oder metallischen Material gebildet ist.

2. Substrat nach Anspruch 1, **dadurch gekennzeichnet, dass** die auf dem Substrat (10) angeordnete Schicht (12) eine Verbindung der Formel SiOₓ enthält oder daraus besteht, wobei x eine Zahl von 0.9 bis 2.0, vorzugsweise eine Zahl zwischen 1.5 und 1.8, ist.

3. Substrat nach Anspruch 2, **dadurch gekennzeichnet, dass** die auf dem Substrat (10) angeordnete Schicht (12) aus oxidkeramischem Material eine Dicke von 50 bis 2000 nm, vorzugsweise 100 bis 1000 nm, insbesondere 150 bis 500 nm, aufweist.

4. Substrat nach Anspruch 1, **dadurch gekennzeichnet, dass** die auf dem Substrat (10) angeordnete Schicht (14) aus Metall, insbesondere aus Chrom, Aluminium, Nickel, Titan, Eisen, Molybdän oder aus einer wenigstens zwei dieser Metalle zusammengesetzten Legierung besteht.

5. Substrat nach Anspruch 4, **dadurch gekennzeichnet, dass** die Metallschicht (14) eine Dicke von max. 5 nm, vorzugsweise eine einer monoatomaren Belegung entsprechende Schichtdicke von 0.1 bis 0.5 nm, aufweist.

6. Substrat nach den Ansprüchen 3 und 5, **dadurch gekennzeichnet, dass** auf dem Substrat (10) eine erste Schicht (12) aus SiOₓ einer Dicke von 50 bis 2000 nm, vorzugsweise 100 bis 1000 nm, insbesondere 150 bis 500 nm, und auf der ersten Schicht (12) aus SiOₓ eine zweite Schicht (14) aus Metall einer Dicke von max. 5 nm, vorzugsweise einer monoatomaren Belegung entsprechenden Schichtdicke von 0.1 bis 0.5 nm, angeordnet ist.

7. Substrat nach einem der Ansprüche 1 bis 6, **dadurch gekennzeichnet, dass** das Substrat (10) eine Kunststofffolie, insbesondere aus einem Polyester, vorzugsweise aus Polyethylenterephtalat (PET), aus orientiertem Polyamid (oPA) oder aus orientiertem Polypropylen (oPP), aufweist oder daraus besteht.

8. Verfahren zur Herstellung eines Substrats mit hydrophiler Oberfläche und einer auf der hydrophilen Oberfläche aufgedruckten Struktur aus einem leitfähigen und/oder organischen Polymer,
**dadurch gekennzeichnet, dass**
ein Substrat mit einem oxidkeramischen und/oder metallischen Material beschichtet und das beschichtete Substrat mit einer wässrigen Dispersion eines leitfähigen und/oder lichtemittierenden organischen Polymers bedruckt wird.

9. Verfahren nach Anspruch 8, **dadurch gekennzeichnet, dass** das Substrat mit SiOₓ, wobei x eine Zahl von 0.9 bis 2.0, vorzugsweise eine Zahl zwischen 1.5 und 1.8 ist, beschichtet wird.

10. Verfahren nach Anspruch 8, **dadurch gekennzeichnet, dass** das Substrat mit Metall, insbesondere mit Chrom, Aluminium, Nickel, Titan, Eisen, Molybdän oder mit einer wenigstens zwei dieser Metalle zusammengesetzten Legierung beschichtet wird.

11. Verfahren nach den Ansprüchen 9 und 10, **dadurch gekennzeichnet, dass** das Substrat mit SiOₓ, wobei x eine Zahl von 0.9 bis 2.0, vorzugsweise eine Zahl zwischen 1.5 und 1.8 ist, und das mit SiOₓ beschichtete Substrat anschliessend mit Metall, insbesondere mit Chrom, beschichtet wird.

12. Verfahren nach Anspruch 8, **dadurch gekennzeichnet, dass** das Metall in Linie mit dem oxidkeramischen Materials auf dem Substrat abgeschieden wird.
